# EUROPEAN PATENT APPLICATION

(11) **EP 2 634 793 A2**
(43) Date of publication of application: **04.09.2013**
(21) Application number: 13160230.2
(22) Date of filing: 02.06.2003
(51) Int. Cl.: H01J 49/00, H01J 49/28, H01J 49/42

(54) **Mass spectrometer with improved mass accuracy**

(30) Priority: 31.05.2002 US 384742 P
(62) Divisional of application: 03731502.5
(71) Applicant: Thermo Finnigan LLC, San Jose, CA 95134 (US)
(72) Inventor: Schoen, Alan E., Saratoga, CA 95070 (US); Heller, Rexford T., San Jose, CA 95134 (US); Schweingruber, Hans, Mountain, View, CA 94040 (US)
(74) Representative: Frost, Alex John

(57) **Abstract**

Mass spectrometers, and methods and apparatus, including computer program products, for operating the same, implement techniques for measuring mass of one or more analyte ions with high mass accuracy. The techniques include a calibration procedure that includes multiple calibration steps to account for system non-linearities. Components of a control system can be disposed in a thermally-controlled environment on a printed circuit board.

## Description

### CROSS REFERENCE TO RELATED APPLICATIONS

This application claims the benefit of provisional application number 60/384,742, filed May 31, 2002, which is incorporated by reference herein.

### BACKGROUND

The present invention relates to mass analysis methods and apparatus in which the mass filtering action of the apparatus is scanned by an analog system that is digitally controlled.

In high performance mass spectrometry it is usually desired to obtain the best accuracy possible in determining the composition of the sample or molecule that is being measured. Two key attributes help determine this. The first, resolution, is the ability of the mass spectrometer to distinguish between ions of different mass-to-charge ratios. The second, mass accuracy, is the ability of the mass spectrometer to accurately determine the mass-to-charge ratios of the ions being measured.

Greater resolution corresponds directly to the increased ability to differentiate ions of similar molecular weights. The ability to differentiate two ions of similar mass-to-charge ratio from each other is directly related to the ability to observe separate mass-peaks for those ions in a mass spectrum. The better the resolution, the more accurately the mass of the unknown chemical species can be measured, and the more easily the mass peak of that species can be differentiated from background noise or from the mass peaks of other chemical species that are close in mass to the unknown species.

An additional advantage of high-resolution mass spectrometry measurement is to eliminate chemical background of the same nominal mass but different accurate mass and, therefore, to increase the signal-to-noise ratio and the sensitivity respectively. With low resolution, only a combined spectral result is obtained. With high resolution, separate detection and therefore separate isolation and MAIMS spectra are obtained.

Resolution is affected by, amongst other things, the instrument design and configuration. Instrument manufacturers typically specify resolution for well-known molecules handled under standard sample preparation procedures and analyzed with optimized instrumental settings. Manufacturers generally provide specifications for the different modes of operation available in their machines. Mass accuracy provides a measure of the maximum error expected during the determination of molecular weights. Mass accuracy is affected, amongst other things, by the type of analyte, instrument design, instrument configuration, sample preparation and mass-axis calibration (internal or external) methods.

Exact mass can be used to confirm an elemental composition in a reasonably small molecule. In this instance, one calculates the theoretical "exact mass" by summing up the masses of all the atoms expected to be in the compound. This calculated mass is then compared to the experimentally measured mass to determine if they agree within an expected tolerance such as the typical 5 parts per million (ppm) specification that is generally acceptable. Measuring the accurate mass in these cases is relatively straightforward because one knows what the answer should be before making the mass spectrometric measurement. Sufficient accuracy to reject probable alternatives is all that is required.

The complimentary process is more difficult. In this case the elemental composition of the sample is not known, so one begins by measuring the accurate mass of the sample. One generally works on the assumption that the actual mass is within the average error (5 ppm). However if the molecule contains several different elements, there may be many elemental formulae that will fit within the +/-5 ppm average error range. It becomes apparent that +/-1 ppm or better error is required for "accurate mass tags", at least, for example, for the identification of peptides.

Commercial instrument manufacturers typically specify mass accuracies as relative errors in units of percentage (%) or parts-per-million (ppm). As for resolution, separate mass accuracy specifications are typically provided for mass determinations based on internal and external calibration methods and different modes of operations in mass spectrometers.

In many types of mass spectrometer, a control voltage is scanned to vary the mass selection - for example, to selectively eject ions from the ion trap, or to selectively pass ions through the mass selective filter. The linearity and precision of the swept voltage determines the accuracy with which the mass of selected ions can be determined. Mass spectrometers that use a digitally controlled voltage source to select a mass range suffer resolution losses due to the errors inherent in converting a digital control word to an analog voltage.

### SUMMARY

The invention provides techniques for precisely and accurately determining the mass of ions. In general, in one aspect, the invention features methods and apparatus, including computer program products, implementing techniques for operating a mass spectrometer including an ion production means, a mass analyzer, an ion detector, and a control means. The techniques include performing a DAC calibration to calibrate an output voltage response of a digital-to-analog converter of the control means, performing a first mass axis calibration, the first mass axis calibration being a primary calibration of a response of the mass analyzer, and performing a second mass axis calibration to calibrate the response of the mass analyzer across a mass range of the mass spectrometer to characterize the imperfections of the instrument's response.

Particular implementations can include one or more of the following features. The steps of the calibration can be performed in the order recited above, or in different orders. The first mass axis calibration can be repeated after performing the second mass axis calibration. The control means can include one or more elements disposed in a thermally controlled environment. A lock mass calibration can be performed to define a linear correction between lock masses of a plurality of lock masses. The mass analyzer response can be calibrated to an accuracy of 1 mmu across a mass range of 1500 AMU. The mass analyzer response can be calibrated to a linearity of at least two parts in 1,500,000.

The DAC calibration can include calculating an analog output voltage error at each of a plurality of set points of a main digital-to-analog converter of the control means, and defining an analog trim voltage corresponding to each of the plurality of set points. The analog trim voltage can be a voltage to be output by a trim digital-to-analog converter of the control means. The main digital-to-analog converter and the trim digital-to-analog converter can together comprise a composite digital-to-analog converter, the composite digital-to-analog converter being a 10 volt device, linear to at least 7 microvolts and requiring less than 24 bits of control. Calculating an analog output voltage error of the main digital-to-analog converter can include comparing an analog output voltage of the main digital-to-analog converter to an expected output voltage at each of more than 2000 set points. Defining an analog trim voltage can include storing a plurality of trim values, each trim value corresponding to a correction to be applied by the trim digital-to-analog converter at each of the plurality of set points of the main digital-to-analog converter. The trim digital-to-analog converter can be used to interpolate between set points of the main digital-to-analog converter.

Performing a first mass axis calibration can include performing a coarse calibration of a response of the mass analyzer at two mass points. Performing a second mass axis calibration can include introducing a sample including a plurality of species having known masses across a mass range of the mass spectrometer, measuring masses of the species in the sample, calculating a deviation of each of the measured masses from a known mass of the corresponding species, performing a piece-wise polynomial fit to correct the deviation for each of the measured masses, and storing a plurality of correction values based on the polynomial fit, the correction values corresponding to corrected analog output voltages for a digital-to-analog converter of the control means. Performing a piece-wise polynomial fit can include performing a spline fit.

The techniques can include compensating for slew rate dependencies to keep measured mass peaks in position as a scan rate is adjusted. Compensating for slew rate dependencies can include performing a real-time mass calculation and adjusting a time scale for data acquisition such that a time per sample ratio is adjusted to provide for a constant ratio of atomic mass unit per sample. The techniques can include introducing a sample into the mass spectrometer, and measuring an accurate mass of an ion derived from a species in the sample.

In general, in another aspect, the invention features a mass spectrometer including a mass selection means for determining a mass of a selected ion. The mass selection means includes a control means capable of providing an analog control voltage. The control means is capable of providing mass selection that varies linearly, and includes one or more elements disposed in a thermally controlled environment.

Particular implementations can include one or more of the following features. The mass selection means can include a means for scanning the amplitude of an RF field. The one or more elements can include one or more components selected from the group consisting of precision digital to analog converters, associated operational amplifiers, gain setting resistors, and RF detection diodes. The one or more elements can include at least two digital to analog converters.

The thermally controlled environment can include one or more resistive heating elements integrated or embedded into a printed circuit board. The one or more heating elements can include one or more copper traces. The heating elements can be configured to provide a smoothly varying amount of heat to one or more regions the printed circuit board. The printed circuit board can include two or more layers, and one or more of the heating elements can be distributed across at least a portion of at least two of the layers. The heating elements can be configured to regulate a temperature of the thermally controlled environment within a range of +/-0.5°C, +/-0.2°C, or +/-0.05°C.

The printed circuit board can include a boundary defining a thermally controlled region. The boundary can be defined by one or more gaps, slots, or perforations. The thermally controlled environment can include an insulation member substantially covering a surface of a temperature-controlled region.

The mass spectrometer can include a mass analyzer into which ions are introduced for mass analysis. The mass analyzer can include at least 2 pairs of hyperbolic rods. The rods can be fabricated to an accuracy of better than 2 parts in 6000, 1 part in 6000, or 2 parts in 8000. The mass analyzer can include a resonant tank circuit that includes at least two pairs of conductive rods, a RF amplifier, a transformer, a DC amplifier and a capacitor. The tank circuit can have a high Q, of greater than 300, greater than 500, or greater than 700. At least one winding of the transformer can include multi-stranded litz wire. A tuning ring of the transformer can include litz wire. The tuning ring can include litz wire having a gauge and number of turns such that an RF resistance of the tuning ring is substantially zero.

In general, in another aspect, the invention features a mass spectrometer that includes a mass analyzer for receiving ions for mass analysis. The analyzer includes a resonant tank circuit comprising at least one transformer comprising a tuning ring formed from litz wire.

In general, in another aspect, the invention features a linearized sweep voltage generation circuit for controlling a mass analyzer. The circuit includes a digital control means for specifying a digital control word corresponding to a desired mass setpoint in the mass analyzer, a main digital-to-analog converter coupled to the digital control means, and a trim digital-to-analog converter coupled to the digital control means. The main digital-to-analog converter is configured to receive a digital control word from the digital control means and to generate an analog output voltage to control the mass analyzer based on digital control word. The main digital-to-analog converter has an error at each of a plurality of set points. The trim digital-to-analog converter is configured to receive a digital trim word from the digital control means and to generate an analog trim voltage to correct for an error in the analog output voltage generated by the main digital-to-analog converter, such that a given analog output voltage and the corresponding analog trim voltage sum to an analog set voltage for the desired mass setpoint for the corresponding digital control word.

Particular implementations can include one or more of the following features. The circuit can include a trim lookup table storing a plurality of digital trim words. Each digital trim word can correspond to one of a plurality of digital control words. Each digital trim word can represent an analog trim voltage that can be generated by the trim digital-to-analog converter to correct an error in the analog output voltage generated by the main digital-to-analog converter for the corresponding digital control word. One or more elements of the circuit can be disposed on a thermally controlled region of a printed circuit board.

The invention can be implemented to provide one or more of the following advantages. Precise calibration of the mass spectrometer can permit accurate mass measurements to be attained. In some embodiments, utilization of a calibration procedure according to the invention can enable a mass accuracy to as little as 1 mmu on a mass spectrometer capable of measuring 1500 amu. The techniques can be used where system performance is not sufficiently linear to allow the use of lock masses to accurately assign the position of unknown peaks.

The details of one or more embodiments of the invention are set forth in the accompanying drawings and the description below. Unless otherwise defined, all technical and scientific terms used herein have the meaning commonly understood by one of ordinary skill in the art to which this invention belongs. All publications, patent applications, patents, and other references mentioned herein are incorporated by reference in their entirety. In case of conflict, the present specification, including definitions, will control. Other features and advantages of the invention will become apparent from the description, the drawings, and the claims.

The following numbered clauses show further illustrative examples:
1. A method for operating a mass spectrometer including an ion production means, a mass analyzer, an ion detector, and a control means, the method comprising:
   (a) performing a DAC calibration to calibrate an output voltage response of a digital-to-analog converter of the control means;
   (b) performing a first mass axis calibration, the first mass axis calibration being a primary calibration of a response of the mass analyzer; and
   (c) performing a second mass axis calibration to calibrate the response of the mass analyzer across a mass range of the mass spectrometer to characterize the imperfections of the instrument's response.
2. A method according toclause 1, wherein:
   the steps (a) through (c) are performed in the order recited.
3. A method according to clause 1, further comprising:
   repeating step (b) after step (c).
4. A method according to clause 1, wherein:
   the control means comprises one or more elements disposed in a thermally controlled environment.
5. A method according to clause 1, further comprising:
   (d) performing a lock mass calibration to define a linear correction between lock masses of a plurality of lock masses.
6. A method according to clause 1, wherein:
   the mass analyzer response is calibrated to an accuracy of 1 mmu across a mass range of 1500 AMU.
7. A method according to clause 1, wherein:
   the mass analyzer response is calibrated to a linearity of at least two parts in 1,500,000.
8. A method according to clause 1, wherein performing the DAC calibration comprises:
   calculating an analog output voltage error at each of a plurality of set points of a main digital-to-analog converter of the control means; and
   defining an analog trim voltage corresponding to each of the plurality of set points, the analog trim voltage being a voltage to be output by a trim digital-to-analog converter of the control means.
9. A method according to clause 8, wherein:
   the main digital-to-analog converter and the trim digital-to-analog converter together comprise a composite digital-to-analog converter, the composite digital-to-analog converter being a 10 volt device, linear to at least 7 microvolts and requiring less than 24 bits of control.
10. A method according to clause 8, wherein:
   calculating an analog output voltage error of the main digital-to-analog converter comprises comparing an analog output voltage of the main digital-to-analog converter to an expected output voltage at each of more than 2000 set points.
11. A method according to clause 8, wherein:
   defining an analog trim voltage comprises storing a plurality of trim values, each trim value corresponding to a correction to be applied by the trim digital-to-analog converter at each of the plurality of set points of the main digital-to-analog converter.
12. A method according to clause 8, wherein:
   the trim digital-to-analog converter is used to interpolate between set points of the main digital-to-analog converter.
13. A method according to clause 1, wherein:
   performing a first mass axis calibration comprises performing a coarse calibration of a response of the mass analyzer at two mass points.
14. A method according to clause 1, wherein performing a second mass axis calibration comprises:
   introducing a sample including a plurality of species having known masses across a mass range of the mass spectrometer;
   measuring masses of the species in the sample;
   calculating a deviation of each of the measured masses from a known mass of the corresponding species;
   performing a piece-wise polynomial fit to correct the deviation for each of the measured masses; and
   storing a plurality of correction values based on the polynomial fit, the correction values corresponding to corrected analog output voltages for a digital-to-analog converter of the control means.
15. A method according to clause 14, wherein:
   performing a piece-wise polynomial fit comprises performing a spline fit.
16. A method according to clause 1, further comprising:
   compensating for slew rate dependencies to keep measured mass peaks in position as a scan rate is adjusted.
17. A method according to clause 16, wherein:
   compensating for slew rate dependencies comprises performing a real-time mass calculation and adjusting a time scale for data acquisition such that a time per sample ratio is adjusted to provide for a constant ratio of atomic mass unit per sample.
18. A method according to clause 1, further comprising:
   introducing a sample into the mass spectrometer; and
   measuring an accurate mass of an ion derived from a species in the sample.
19. A computer program product embodied in a tangible medium for operating a mass spectrometer including an ion production means, a mass analyzer, an ion detector, and a control means, the computer program product comprising instructions operable to cause a programmable processor to:
   (a) perform a DAC calibration to calibrate an output voltage response of a digital-to-analog converter of the control means;
   (b) perform a first mass axis calibration, the first mass axis calibration being a primary calibration of a response of the mass analyzer; and
   (c) perform a second mass axis calibration to calibrate the response of the mass analyzer across a mass range of the mass spectrometer to characterize the imperfections of the instrument's response.
20. A computer program product according to clause 19, wherein:
   the instructions are operable to cause a programmable processor to perform steps (a) through (c) in the order recited.
21. A computer program product according to clause 19, further comprising instructions operable to cause a programmable processor to:
   repeat step (b) after step (c).
22. A computer program product according to clause 19, wherein:
   the control means comprises one or more elements disposed in a thermally controlled environment.
23. A computer program product according to clause 19, further comprising instructions operable to cause a programmable processor to:
   (d) perform a lock mass calibration to define a linear correction between lock masses of a plurality of lock masses.
24. A computer program product according to clause 19, wherein:
   the mass analyzer response is calibrated to an accuracy of 1 mmu across a mass range of 1500 AMU.
25. A computer program product according to clause 19, wherein:
   the mass analyzer response is calibrated to a linearity of at least two parts in 1,500,000.
26. A computer program product according to clause 19, wherein the instructions operable to cause a programmable processor to perform the DAC calibration comprise instructions operable to cause a programmable processor to:
   calculate an analog output voltage error at each of a plurality of set points of a main digital-to-analog converter of the control means; and
   define an analog trim voltage corresponding to each of the plurality of set points, the analog trim voltage being a voltage to be output by a trim digital-to-analog converter of the control means.
27. A computer program product according to clause 26, wherein:
   the main digital-to-analog converter and the trim digital-to-analog converter together comprise a composite digital-to-analog converter, the composite digital-to-analog converter being a 10 volt device, linear to at least 7 microvolts and requiring less than 24 bits of control.
28. A computer program product according to clause 26, wherein the instructions operable to cause a programmable processor to calculate an analog output voltage error of the main digital-to-analog converter comprise instructions operable to cause a programmable processor to:
   compare an analog output voltage of the main digital-to-analog converter to an expected output voltage at each of more than 2000 set points.
29. A computer program product according to clause 26, wherein the instructions operable to cause a programmable processor to define an analog trim voltage comprise instructions operable to cause a programmable processor to:
   store a plurality of trim values, each trim value corresponding to a correction to be applied by the trim digital-to-analog converter at each of the plurality of set points of the main digital-to-analog converter.
30. A computer program product according to clause 26, wherein:
   the trim digital-to-analog converter is used to interpolate between set points of the main digital-to-analog converter.
31. A computer program product according to clause 19, wherein the instructions operable to cause a programmable processor to perform a first mass axis calibration comprise instructions operable to cause a programmable processor to:
   perform a coarse calibration of a response of the mass analyzer at two mass points.
32. A computer program product according to clause 19, wherein the instructions operable to cause a programmable processor to perform a second mass axis calibration comprise instructions operable to cause a programmable processor to:
   receive signals identifying measured masses of a plurality of species in a sample, the plurality of species having known masses across a mass range of the mass spectrometer;
   calculate a deviation of each of the measured masses from a known mass of the corresponding species;
   perform a piece-wise polynomial fit to correct the deviation for each of the measured masses; and
   store a plurality of correction values based on the polynomial fit, the correction values corresponding to corrected analog output voltages for a digital-to-analog converter of the control means.
33. A computer program product according to clause 32, wherein the instructions operable to cause a programmable processor to performing a piece-wise polynomial fit comprise instructions operable to cause a programmable processor to:
   perform a spline fit.
34. A computer program product according to clause 19, further comprising instructions operable to cause a programmable processor to:
   compensate for slew rate dependencies to keep measured mass peaks in position as a scan rate is adjusted.
35. A computer program product according to clause 34, wherein the instructions operable to cause a programmable processor to compensate for slew rate dependencies comprise instructions operable to cause a programmable processor to:
   perform a real-time mass calculation and adjusting a time scale for data acquisition such that a time per sample ratio is adjusted to provide for a constant ratio of atomic mass unit per sample.
36. A computer program product according to clause 19, further comprising instructions operable to cause a programmable processor to:
   receive a signal corresponding to a measured mass of an ion derived from a species in a sample introduced into the mass spectrometer; and
   calculate an accurate mass of the ion.
37. A mass spectrometer, comprising:
   a mass selection means for determining a mass of a selected ion, the mass selection means comprising a control means capable of providing an analog control voltage, the control means being capable of providing mass selection that varies linearly, the control means comprising one or more elements disposed in a thermally controlled environment.
38. A mass spectrometer according to clause 37, wherein:
   the mass selection means comprises a means for scanning the amplitude of an RF field.
39. A mass spectrometer according to clause 37, wherein:
   the one or more elements comprise one or more components selected from the group consisting of precision digital to analog converters, associated operational amplifiers, gain setting resistors, and RF detection diodes.
40. A mass spectrometer according to clause 37, wherein:
   the one or more elements comprise at least two digital to analog converters.
41. A mass spectrometer according to clause 37, wherein:
   the thermally controlled environment comprises one or more resistive heating elements integrated or embedded into a printed circuit board.
42. A mass spectrometer according to clause 41, wherein:
   the one or more heating elements comprise one or more copper traces.
43. A mass spectrometer according to clause 41, wherein:
   the heating elements are configured to provide a smoothly-varying amount of heat to one or more regions the printed circuit board.
44. A mass spectrometer according to clause 41, wherein:
   the printed circuit board comprises two or more layers; and
   one or more of the heating elements are distributed across at least a portion of at least two of the layers.
45. A mass spectrometer according to clause 41, wherein:
   the printed circuit board comprises a boundary defining a thermally controlled region.
46. A mass spectrometer according to clause42, wherein:
   the boundary is defined by one or more gaps, slots, or perforations.
47. A mass spectrometer according to clause 41, wherein:
   the heating elements are configured to regulate a temperature of the thermally controlled environment within a range of +/-0.5°C.
48. A mass spectrometer according to clause 41, wherein:
   the heating elements are configured to regulate a temperature of the thermally controlled environment within a range of +/-0.05°C.
49. A mass spectrometer according to clause 41, wherein:
   the thermally controlled environment comprises an insulation member substantially covering a surface of a temperature controlled region.
50. A mass spectrometer according to clause 37, further comprising:
   a mass analyzer into which ions are introduced for mass analysis, the mass analyzer comprising at least 2 pairs of hyperbolic rods.
51. A mass spectrometer according to clause 50, wherein:
   the rods are fabricated to an accuracy of better than 2 parts in 6000.
52. A mass spectrometer according to clause50, wherein:
   the rods are fabricated to an accuracy of better than 1 part in 6000.
53. A mass spectrometer according to clause 50, wherein:
   the rods are fabricated to an accuracy of better than 2 parts in 8000.
54. A mass spectrometer according toclause37, further comprising:
   a mass analyzer comprising a resonant tank circuit, the resonant tank circuit comprising at least two pairs of conductive rods, a RF amplifier, a transformer, a DC amplifier and at a capacitor.
55. A mass spectrometer according to clause 54, wherein:
   the tank circuit has a high Q.
56. A mass spectrometer according to clause 55, wherein:
   the tank circuit has a Q of greater than 300.
57. A mass spectrometer according to clause 55, wherein:
   the tank circuit has a Q of greater than 500.
58. A mass spectrometer according to clause 55, wherein:
   the tank circuit has a Q of greater than 700.
59. A mass spectrometer according to clause 54, wherein:
   at least one winding of the transformer comprises multi-stranded litz wire.
60. A mass spectrometer according to clause 54, wherein:
   a tuning ring of the transformer comprises litz wire.
61. A mass spectrometer according to clause 60, wherein:
   the tuning ring comprises litz wire having a gauge and number of turns such that an RF resistance of the tuning ring is substantially zero.
62. A mass spectrometer, comprising:
   a mass analyzer for receiving ions for mass analysis, the analyzer comprising a resonant tank circuit comprising at least one transformer comprising a tuning ring formed from litz wire.
63. A linearized sweep voltage generation circuit for controlling a mass analyzer, comprising:
   digital control means for specifying a digital control word corresponding to a desired mass setpoint in the mass analyzer;
   a main digital-to-analog converter coupled to the digital control means, the main digital-to-analog converter being configured to receive a digital control word from the digital control means and to generate an analog output voltage to control the mass analyzer based on digital control word, the main digital-to-analog converter having an error at each of a plurality of set points; and
   a trim digital-to-analog converter coupled to the digital control means, the trim digital-to-analog converter being configured to receive a digital trim word from the digital control means and to generate an analog trim voltage to correct for an error in the analog output voltage generated by the main digital-to-analog converter, such that a given analog output voltage and the corresponding analog trim voltage sum to an analog set voltage for the desired mass setpoint for the corresponding digital control word.
64. The circuit of clause 63, further comprising:
   a trim lookup table storing a plurality of digital trim words, each digital trim word corresponding to one of a plurality of digital control words, each digital trim word representing an analog trim voltage that can be generated by the trim digital-to-analog converter to correct an error in the analog output voltage generated by the main digital-to-analog converter for the corresponding digital control word.
65. The circuit ofclause63, wherein:
   one or more elements of the circuit are disposed on a thermally controlled region of a printed circuit board.

### BRIEF DESCRIPTION OF THE DRAWINGS

Fig. 1 is a schematic diagram of a mass spectrometer according to one aspect of the invention.
Fig. 2 is a schematic diagram of the digital-to-analog converter (DAC) subsystem for generating the mass analysis control voltage.
Fig. 3 shows the output of the DAC subsystem voltage deviation from linear.
Fig. 4 shows the linearized subsystem voltage.
Fig. 5 shows the mass output prior to mass correction and after mass correction.
FIG. 6 is a schematic diagram of the thermal/temperature control system according to one aspect of the invention.
FIG. 7 is cross-sectional schematic diagram, of the thermal/temperature control system according to one aspect of the invention.
FIG. 8 is schematic diagram of a quadrupole mass spectrometer which can be calibrated by means of one aspect of the present invention.
FIG. 9 is a schematic diagram of a quadrupole ion trap mass spectrometer which can be calibrated by means of one aspect of the present invention.
FIG. 10 is a schematic diagram of a device that can be utilized to vary the angle of the loop within a transformer's flux.
FIG. 11 is a schematic diagram of a triple quadrupole mass spectrometer which can be calibrated by means of one aspect of the present invention.
FIG 12. is a schematic diagram of a magnetic sector mass spectrometer which can be calibrated by means of one aspect of the present invention.

Like reference numbers and designations in the various drawings indicate like elements.

### DETAILED DESCRIPTION

Mass spectrometers measure the mass-to-charge ratios of ions. When the species being observed has a charge of unity, as is typically the case for many common ionization methods, the mass-to-charge ratio and mass of the ion are the same; as a result, it is often said that mass spectrometers measure simply the "mass" of ions. However, several newer ionization techniques, such as electrospray ionization, routinely produce multiply-charged ions. Fortunately, the multiply charged (m/z) states give peaks in the spectrum that can be mathematically processed to derive the original molecular mass of the molecule. In this specification, the term "mass" is used to refer to either mass (when the charge of the ions has been accounted for) or mass-to-charge ratio (when the charge of the ions has not been accounted for).

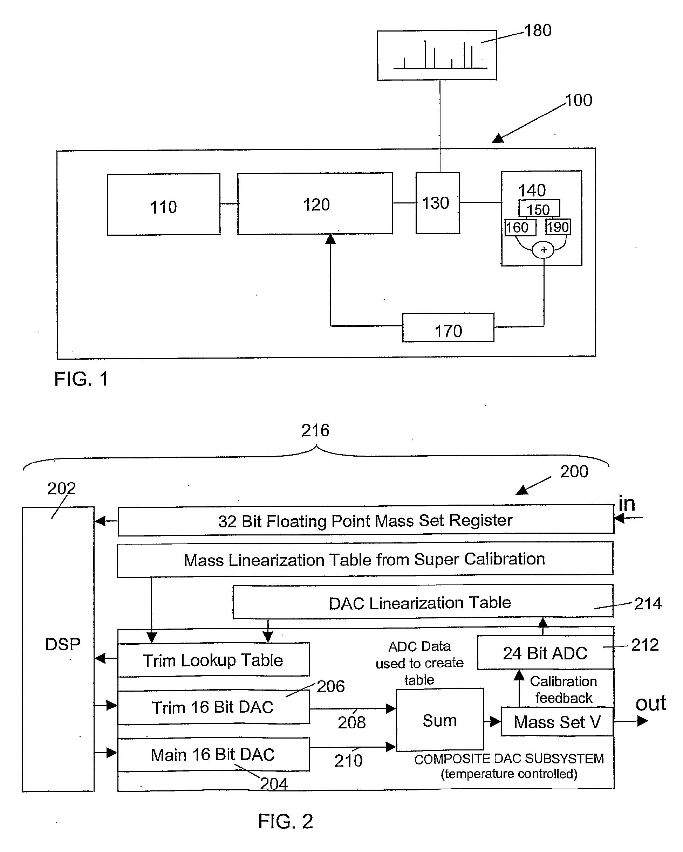

FIG. 1 is a schematic diagram of a mass spectrometer 100 according to one aspect of the invention. Mass spectrometer 100 includes an ion production means 110, a mass analyzer 120, an ion detector 130, and a control means 140, which includes a digital signal processor (DSP) 150 and a digital-to-analog converter (DAC) 160, followed by an analog system 170 that receives an analog control signal from DAC 160 and processes the analog control signal, causing mass analyzer 120 to transmit ions of a selected mass or mass range to ion detector 130.

In operation, ions derived from the ion production means 110 are transmitted into mass analyzer 120. In mass analyzer 120, ions are separated according to their mass-to-charge ratio, and ions of a desired mass-to-charge ratio (or range of mass-to-charge ratios) are passed to the detector, where an ion signal is obtained and processed to provide a mass spectrum 180. The separation in mass analyzer 120 is carried out under the control of DSP 150, which is coupled to DAC 160. To select a desired mass range for transmission to detector 130, DSP 150 outputs to DAC 160 a digital control word corresponding to a desired DC voltage level that corresponds to the desired mass range in mass analyzer 120. DAC 160 converts the digital control word into an analog output voltage.

Commercially available DACs 160 are not perfect, i.e. do not have the desired resolution or accuracy (for example, to obtain the +/-5ppm or +/-1ppm figure mentioned earlier) and deviate from the desired path, for example may be non-linear, the analog output voltage deviating from the expected voltage for the value of the digital control word that is received from DSP 150. To correct this inherent error (e.g., non-linearity), the output voltage of DAC 160 is "trimmed" using a second DAC 190 having a finer quantization (i.e., a smaller voltage change per least significant bit change). It should be noted that in this specification, "linear" and "linearity" are not limited to the characteristic or property of lying along a straight line defined by the equation y=mx+b, but extend to lines defined by other equations as well, such as quadratic functions, exponential functions, and the like. The second DAC 190, when programmed with the correct trim value, outputs a voltage that corrects any variance for a given DSP digital control word between the actual output voltage of the first DAC 160 and its expected output voltage. This corrected voltage is supplied to the analog system 170, which causes mass analyzer 120 to transmit ions of the selected mass or mass range to detector 130. The linearity and precision of this process determines the accuracy with which the mass of selected ions can be determined.

The source of ions 110 can be any of a variety of conventional ion sources, such as an atmospheric pressure chemical ionization (APCI) source, an atmospheric pressure photo-ionization (APPI) source, an atmospheric pressure photo-chemical-ionization (APPCI) source, a matrix assisted laser desorption ionization (MALDI) source, an atmospheric pressure MALDI(AP-MALDI) source, an electron impact ionization (EI) source, an electrospray ionization (ESI) source, an electron capture ionization source, a fast atom bombardment source or a secondary ions (SIMS) source, or any other type of ion source.

Mass analyzer 120 can be any of a variety of conventional mass analyzers that can be configured to selectively transmit ions of a given mass or mass range. Thus mass analyzer 120 can include, for example, quadrupole mass filters, quadrupole ion traps, triple quadrupole mass spectrometers, magnetic field type mass spectrometers, and orbitrap mass spectrometers The particular structure of the mass analyzer and the remaining components of system 100 can depend on the type of mass analyzer used.

A calibration curve for the particular mass analyzer defines a precise empirical relationship between the setting of the digital to analog converters (providing digital control) for the analog control system 170, the system typically responsible for the mass selection or ejection. The analog control system 170 will have a mass selection parameter that depends upon the particular analyzer, and may comprise, for example, an RF trapping voltage, or the amplitudes of the applied magnetic, electric or acceleration fields. The calibration curve is generally established using calibration reference samples that are suitable for the mass spectrometer being calibrated, and have masses at well known values distributed across the mass regions of interest. From the calibration chart prepared, one can select a combination of DAC values (providing digital control) which will cause ejection or selection of a specific m/z value.

Instrumental performance can play a significant part in the calibration of mass spectrometers. Short term thermal drift at the component level is difficult to avoid. Most IC specifications list drift per degree Celsius as a part specification. In addition there are strain gauge effects and other well known electronic quirks which are typically ignored as insignificant relative to the overall system performance. For example, the IC lead to circuit board connection at every pin has a thermocouple effect of c.a.10 microvolts per degree Celsius. In some implementations, the techniques described herein attempt to account for some or all of these instrumental quirks. These techniques are particularly applicable to situations in which the overall system performance is not sufficiently correct (or linear) to allow the use of lock masses to accurately assign the position of unknown peaks.

A calibration procedure can be used to compensate for system aberrations. The calibration procedure can include multiple separate calibration functions. In one implementation, three separate system calibration functions are used to measure accurate mass on a mass spectrometer. Alternatively, four or more separate system calibration functions can be used.

A first calibration is a DAC linearization procedure, which is purely a hardware calibration and is generally performed once. This calibration can be performed by the IC manufacturer. Commercial parts usually refer to this as a laser trimmed DAC where the calibration is burned into the chip. Other commercial implementations that utilize dynamic calibration methods can be employed, for example the 16/18-bit self-calibrating serial/byte DACPORT sold by Analog Devices. In some implementations, performing the DAC linearization in situ can provide results superior to those obtainable with such commercially available parts. This DAC linearization is typically carried out after the system has been thermally regulated to the temperature at which it is intended that the device be operated. A commercial DAC that takes an input of 20 bits and is at least capable of performing with a mean linearity of a few microvolts (0-2µV), a standard deviation of less than 5 microvolts, and a peak to peak of 20 microvolts, would provide the performance required to obtain the accuracy sought. The calibration DAC information can be stored (e.g., in a non-volatile memory) for subsequent use.

A second calibration is a normal mass axis calibration, as carried out with the system tune and calibration set up. In one implementation, the mass axis calibration is carried out utilizing only two calibration points, thereby eliminating the chance of inflection points occurring in the system performance. Since this calibration affects piecewise linear corrections, the utilization of more than two calibration points give rise to relatively low performance calibration associated with a typical instrument. The use of only two points is therefore a simple linear coarse calibration. The instrument's intrinsic non-linearity will persist smoothly between and beyond the two coarse calibration points.

A third calibration is a system linearization step, which is also a mass calibration, but is much more obsessive than the standard calibration that is currently carried out in the art. This second mass calibration characterizes system non-linearities across the entire mass range. It measures the position of known peaks across the mass range of interest, thereby allowing the mass peak of an unknown compound to be interpolated from the measured mass of known reference compounds. The combination of these three calibrations to drive the scan generator provides a mass scan function which is truly linear with mass. The two mass calibrations may be combined into a single calibration procedure, but in some implementations it can be advantageous to separate them. The first calibration is applied to the entire DAC subsystem, which retains the full range of trim control for the finer second calibration.

A fourth calibration is the application of lock masses, which is typically performed with all high mass accuracy mass spectrometers. Since the system is linear with mass, the lock mass corrections are simple linear corrections. A single lock peak is applied as an offset and multiple lock peaks define a piecewise linear correction function.

Figure 2 illustrates one embodiment of a digital-to-analog system 200 that is operable to provide for accurate control of the sweep voltage of the mass spectrometer as a function of mass to provide accurate mass measurements according to one aspect of the invention.

The system mass linearity must be precise to allow interpolation from known reference compounds to derive the measurement of the masses of unknown compounds. The DAC or digital-to-analog converter which receives digital output from the DSP 202 and generates the sweep control voltage is the key to the linearity of the sweep voltage.

System 200 includes a digital signal processor (DSP) 202, which provides digital output to two commercial DACs 204 and 206, which can be, e.g., simple 16-bit DACs with R2R ladder networks which have low thermal drift. In this embodiment, DAC 204 operates as a main DAC, while DAC 206 operates as a trim DAC. Eleven bits of DAC 204 are used to generate a number between 0 and 2047. If DAC 204 is supplied with a voltage such that 65,535 (1111 1111 1111 1111 in binary) corresponds to 10 V, then DAC 204 can set a voltage anywhere from 0 to 10 V in steps of approximately 150 microvolts. However, since DAC 204 is not perfect (that is, in this example, non-linear, a particular setting of DAC 204 will not produce the precise output voltage desired.

Accordingly, to correct (i.e., in this example, to linearize) DAC 204, the output 210 of DAC 204 is summed with the output 208 of trim DAC 206, which is attenuated leaving sufficient range to cover the span required to linearize the main DAC plus the zero offset plus the range required to linearize the mass range of the instrument. In one embodiment, the trim value can add anywhere from +/- 7000 microvolts to the output 210 of DAC 204 to trim or linearize it. Thus, for example, a setting in DAC 204 of 3, which corresponds to 0000 0000 0000 0011 in binary may produce a voltage of 437 microvolts instead of the intended 450 microvolts. To linearize DAC 204 in this example, DAC 206 can add 13 microvolts to linearize the output of DAC 204 to 450 microvolts.

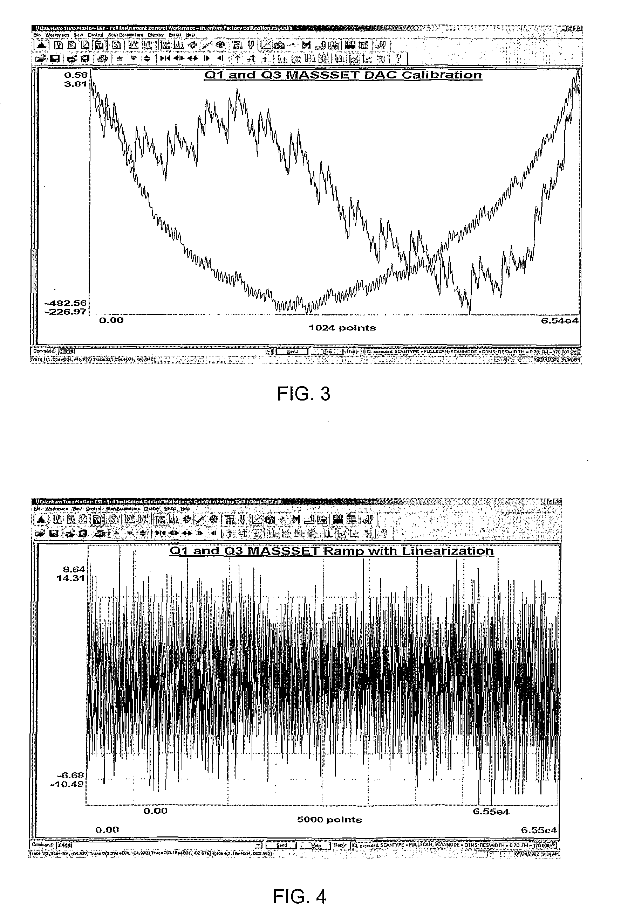

The trim values supplied by trim DAC 206 are stored in a trim lookup table, and are determined as follows. First, the main DAC 204 is programmed at 2048 points using its 11 most significant bits using the precise and linear 24-bitADC 212. The voltages corresponding to these points are then recorded, and their deviations from linearity are measured as shown in Figure 3. These deviations are used to calculate the digital word that must be programmed into DAC 206 to generate an additional output voltage that will trim the output voltage of DAC 204. The trim words are stored in the trim lookup table which, for a given word to be programmed into DAC 204, returns the corresponding trim word that should be programmed into DAC 206 to trim the output voltage of DAC 204 to linearize it.

In addition, the trim DAC 206 is used to interpolate between the 2048 settings of the main DAC 204. The attenuated trim DAC 206 does not require linearization because the attenuated non-linearities are below the system's requirements. However, the ADC 212 is used measure the trim DAC's full scale range precisely, and this information is used to accurately choose the trim DAC settings at each of the 2048 correction points.

Digital signal processor 202 uses this information to set the two DACs 204 and 206 from a single composite DAC set point. In one embodiment, a 32-bit floating point representation for this composite DAC with 7.3 digits of resolution is employed. The resulting system is linear and precise to better than 20 microvolts across the entire 10 volt range with a local set point resolution of 2 microvolts, as illustrated in Figure 4. In one embodiment utilizing a 10 volt DAC, the resulting system was linear to less than 7 microvolts (in one instance as low as 6.6 microvolts) and required less than 24 bits of control (in one instance 20.5 bits of control).

This complete composite DAC subsystem 216 is placed within a temperature controlled environment along with other temperature sensitive elements of the control system. Note that more or fewer bits (relative to the DAC set points) could be recorded, although in one set of experiments it was found that measurement of more set points did not necessarily produce better results, but required more time. Since more time was required to measure the greater number of set points, there was more time available for the temperature of the DAC subsystem to vary or drift and consequently the final calibration did not facilitate better results to be attained.

A system mass linearization is performed to address additional errors or non-linearities within the system. The system linearization measures the position of known peaks across the mass range of interest. Once the DAC 204 has been linearized as discussed above, a sample mixture (preferably with species at evenly spaced intervals along the entire mass range) is introduced into the mass spectrometer, and the positions of the mass peaks are measured. In one embodiment, the sample mixture is a mixture of PEG exhibiting mass peaks at intervals of 44 Daltons, but any suitable mixture can be used as long as the peak positions are known and there are no interfering peaks from the background of the mass spectrometer.

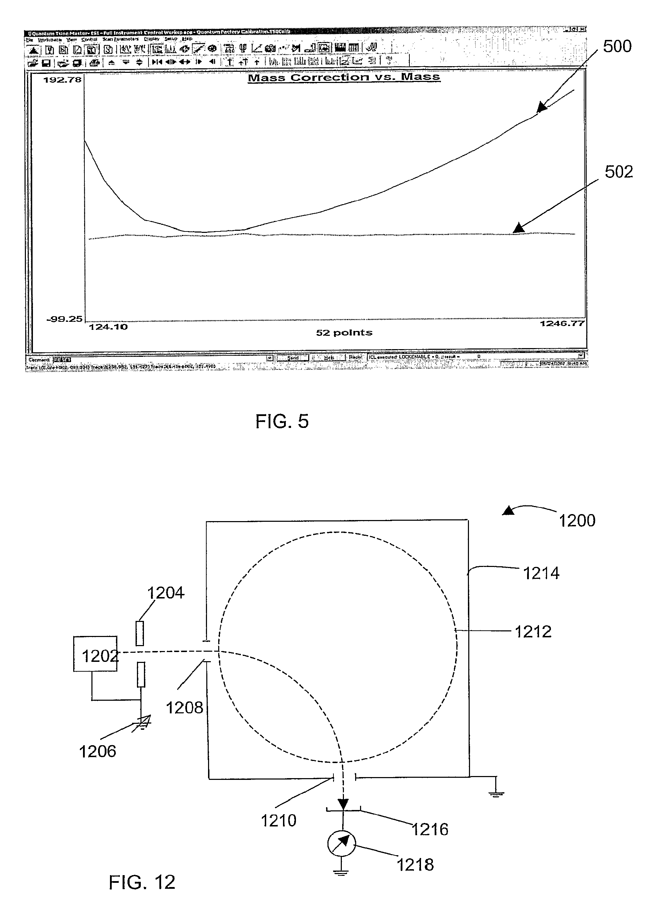

A plot is made showing how the measured mass peaks deviate from the expected mass peaks as a function of mass (or rather, sweep voltage). This is shown as curve 500 in Figure 5. A piece-wise polynomial fit is done to remove the curvature (non-linearity) that is apparent in mass deviation curve 500. Since the measured mass is a function of the sweep voltage supplied to the analog system 170 by DAC 204, the polynomial fit can be used to determine the mass deviation as explained above. These mass deviations can then be corrected by correcting the output voltage of DAC 204, as before, by adjusting the trim values programmed into DAC 206 from the trim table. With these adjusted trim values, the deviations of the mass peaks from the sample mixture as a function of mass or sweep voltage should be corrected. This is accomplished, as shown in curve 502 in Figure 5. Thus, by trimming the output voltage of DAC 206 using the data from the polynomial fit, the mass deviation as a function of mass shown in curve 502 is flat with zero slope, as expected.

In one embodiment, a spline fit, such as a cubic spline fit, is used to correct the mass linearization data at the 2048 set points in the mass DAC's trim table. In performing a spline fit, the domain, or x-axis of the signal, is divided into a number of spline intervals, which are typically of equal size. Each spline interval is represented by a distinct polynomial, for example, a quadratic or cubic equation. At the boundaries between spline intervals, constraints are applied to force the two neighboring equations to be equal in value, first derivative, second derivative, etc., up to one less than the order of the polynomial. For a cubic spline, derivatives up through the second are forced equal at boundaries. For a quadratic spline, only the first derivative is forced equal.

The spline fit ensures that substantially every one of the measured calibration sample mass peaks fits onto the spline. A cubic polynomial is selected for each interval between each of the measured calibration sample mass data points. (One cubic polynomial is not typically chosen over the entire domain.) The cubic polynomials are chosen in such a way as to make the first derivative of the cubic polynomial continuous over the entire domain. The aim here is to obtain a curve which goes through each of the measured calibration mass points, and that provides a smooth continuous curve across the entire measured domain. Among other things, fitting with such a curve interpolates accurately between the calibration points in a manner consistent with the system non-linearity. It has been found that the use of the three step calibration procedure produces excellent results across the entire mass range without the need for lock masses.

When lock masses are used, the linear system performance allows linear interpolation between those lock masses to give accurate results. The final lock mass algorithm simply applies a linear correction to interpolate precisely between lock peaks and accurately assign the measured masses. Without the linearization provided by the preceding calibration steps, good results would only be possible if the lock masses are close to the unknown peak. While the best results are still obtained when the lock masses are close, the penalty for choosing lock masses distant from the unknown is significantly reduced.

In some embodiments, other features can be used to compensate for slew rate dependencies to keep peaks in position as scan rate is adjusted. One of these is ion flight time, which for low eV ions can be significant. For example, in a triple quadrupole mass analyzer, the ion flight time in Q3 can be in the neighborhood of 7 microseconds per SQRT (mass); in Q1 it can be in the neighborhood of 22 microseconds per SQRT (mass). To take advantage of this feature, a digital signal processor can perform a mass calculation on the fly and adjust the time scale for data acquisition to linearize the mass axis. The time per sample is thus adjusted to keep the atomic mass unit (amu) per sample constant. In addition, since time of flight depends upon the voltages for each element within the ion's path, the mass axis is calibrated and adjusts the ion flight time parameter, which has units of microseconds per SQRT (mass), with a lookup table.

While linearization of the DAC can make it possible to make accurate mass measurements, the resulting measurements are accurate only if other non-linearities, deviations or drifts in the system are compensated for, minimized or substantially eliminated.

In some cases, it can be difficult or impossible to keep the thermal stability of the system and its component parts substantially constant. For this reason, materials and tolerances for all components of the mass spectrometer can be chosen such that thermal expansion is limited as much as possible. For example, in one embodiment employing quadrupoles, the quadrupoles are fabricated as hyperbolic rods that are 6mm in "radius" (hyperbolic radius) and with a precision of better than 2 microns accuracy, peak to peak, (which equates to better than two parts in 6000). Tighter tolerances -- for example a tolerance of 1 micron on a 6mm hyperbolic rod (one part in 6000), or a tolerance of 1 micron on a larger hyperbolic radius rod, e.g., 8mm, (one part in 8000) -- would enable measurements with improved mass accuracy. The more precise the machining tolerances, the more precise the mass accuracy results attained. A better design might also place the quadrupoles in a thermally controlled environment.

The response of the circuit components themselves may drift depending upon the environmental conditions, including the thermal environment. Hence, in another aspect the invention facilitates the thermal control of the thermally dependent components by providing a thermally controlled environment for one or more than one thermally dependent components, thus maintaining the temperature of the thermally dependent components at a predetermined temperature. In this manner, it is possible to ensure that the apparatus in question, in this case the mass spectrometer, is both calibrated and operated such that the thermally dependent components are maintained at substantially the same temperature. In the instances where one component is more thermally sensitive than another, compromises can be made on the less sensitive components to accommodate the more sensitive components.

A thermal control system according to this aspect of the invention can be implemented as one or more dedicated energized resistive heating elements, for example copper traces, integrated or embedded into the circuit board. The heaters are coupled to a power source by thermal control circuitry, and are configured to provide a level of heat to particular regions of the circuit board that satisfies the predetermined temperature criteria of the temperature-dependent components in the respective regions. The components mounted in such temperature controlled regions can include one or more of precision DACs, associated operational amplifiers, gain setting resistors, and RF detection diodes.

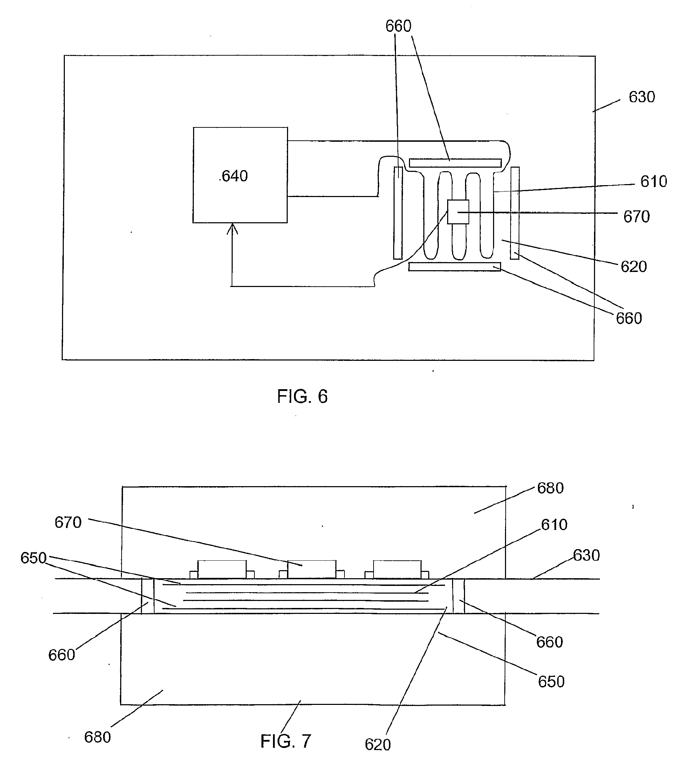

In one embodiment, as shown in Figs. 6 and 7, the heaters 610 are configured to provide a smoothly-varying amount of heat to different segments/regions 620 of the circuit board 630, and not merely different levels (switching or cycling from low or high power for example) of heat. In this embodiment, the power delivered to the heaters 610 can be varied smoothly, via a PID (proportional integral differential) control algorithm 640 such that the temperature of the circuit board segment 620 can be precisely maintained. The relatively low electrical resistivity of the copper traces (which represent the heater 610) is such that the length of the copper traces must be great enough to provide the required resistance. Due to the length of these copper traces, the copper traces evenly cover one or more layers of the entire region 620 being controlled, with spacing sufficient to allow any vias needed for the circuit being heated. To assist the heat provided by the copper heater 610 traces to spread throughout the region 620, copper planes 650 can be provided above and/or below the copper heater traces.

A boundary in the form of a gap, slots, or a set of perforations 660 defines the area 620 of the circuit board 630 that is to be controlled. This boundary physically isolates the region 620 of the circuit board 630 which is required to be maintained at a substantially constant temperature. This minimizes the power needed to maintain the temperature, and minimizes temperature gradients across the temperature controlled region. It is known that components characteristics, such as resistance of resistors, or offset voltages of amplifiers, are affected to varying degrees by temperature. In addition, each soldered connection between a component lead and the circuit board forms a thermocouple. The net effect of all these thermocouples depends on the differences between temperatures of different connections, and is minimized if the temperature differences are minimized. The boundary can also function to relieve stress coupled through the lead frames to integrated circuit components that might otherwise induce shifts in characteristics such as regulated voltages of voltage references.

A power regulator 640 supplies power to the heaters 610 disposed on the thermally controlled circuit board 630. The power source can be a standard commercial power supply. A temperature sensor 670 is located in the temperature controlled region 620 and information from this sensor 670 is used to throttle the power regulator to produce a constant temperature at the temperature sensor 670. In embodiments, the temperature of the thermally controlled environment can be regulated to within +/- 0.5°C, +/- 0.2°C , or +/- 0.05°C or better, for example, to approximately 0.01 degrees Celsius, during operation of the mass spectrometer. The circuit board 630 can have an insulation member(s) 680 which substantially covers the top and bottom surfaces of at least one temperature controlled region 620, in order to minimize heat loss by convection and conduction, and minimize heater power requirements.

Utilization of a thermally controlled environment in conjunction with the calibration method identified above (for the quadrupole mass spectrometer embodiment described below, incorporating substantially all the enhancements discussed later in this application, including a Litz wire tuning ring, high Q tank circuit and the copper trace integrated heater), allows a linearity of at least two parts in one and a half million to be attained; in one particular experiment, a linearity of 1.5 part in one and half million was reached.

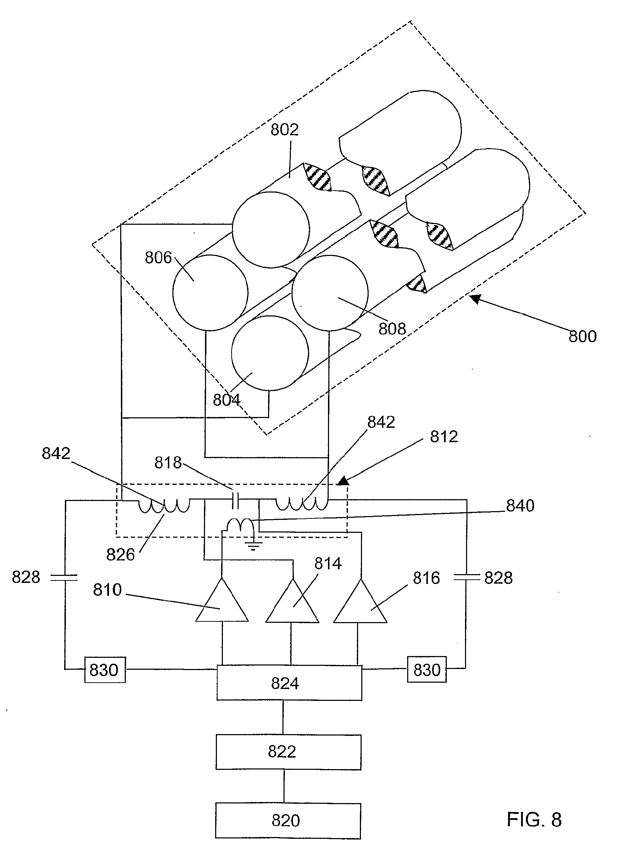

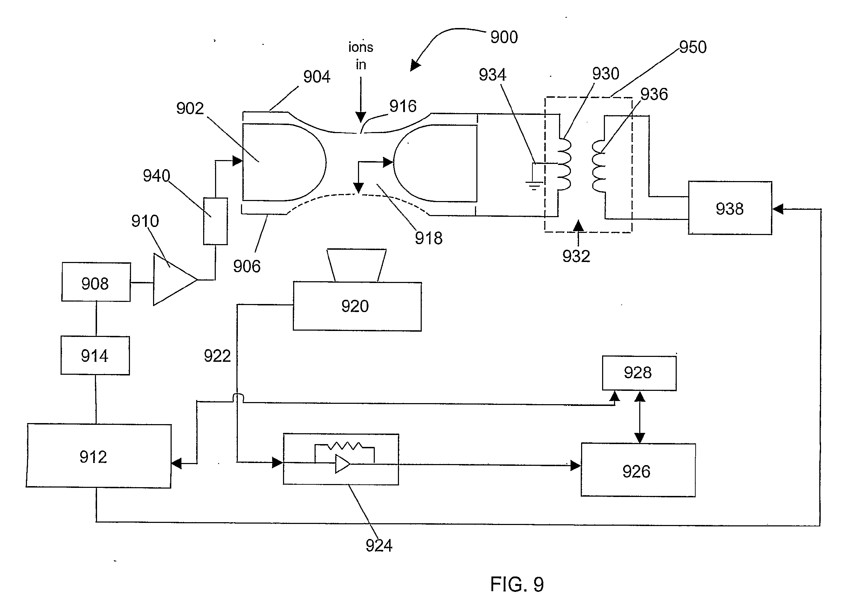

In another aspect, the invention features a resonant circuit (a tank circuit) having a high Q value, (typically greater than 300, and in some embodiments in the order of 400, 500, 600, or even as high as 700). In general terms, the circuit used to connect the selection parameter of the analog system (e.g. the RF voltage) to the component(s) that facilitate mass selection/ejection in the mass analyzer, (e.g. for a quadrupole mass filter, the quadrupole and the rod drivers) comprises a tank circuit. This tank circuit supplies the RF voltage to the quadrupole field devices, the quadrupole mass filter, and the 2- and 3-D quadrupole ion trap mass analyzer, for example. The tank circuit or RF resonant transformer secondary is used to transfer RF and DC to the quadrupoles. Referring to Fig. 8, the tank circuit 812 controls a primary winding 840 and a secondary winding 842 connected to the quadrupole 802, 804, 806, 808. (One should note in reality the tank circuit 812 comprises the quadrupole 802, 804, 806, 808 along with the primary 840 and secondary 842 of the coil). The quadrupole represents a capacitance. Referring to Fig.9, the tank circuit 950 is used to connect the supplementary RF amplitude generator 938 to the end caps 904, 906 of the ion trap 900. (One should note that in reality the tank circuit 950 comprises the end caps of the ion trap 904, 906, along with the primary 936 and the secondary 930 of the coil.) Q is a parameter that defines the quality of a resonant circuit, and it is defined as the ratio of the center frequency to the bandwidth at the 3dB point..

Good spectra depend upon a pure RF, both in frequency content and amplitude stability. The contribution of the tank circuit quality or Q to this is considerable. The higher the value of Q for the tank circuit, the greater its ability to reject harmonics. Harmonics cause errors in the RF amplitude at the fundamental frequency because they cause errors in the measured RF amplitude, which provides the feedback to regulate the RF amplitude applied to a quadrupole mass filter or ion trap so that it follows the commanded mass selection voltage from the DAC. The higher the value of Q for the tank circuit, the less power loss and heating experienced in the circuit, and the more stable the resonant frequency. If the system were to detune (due to mechanical vibration, for example), the most stable place of operation would be the peak of the resonance curve. At the peak, the slope of the curve is zero, and any shift experienced by detuning would cause operation to occur at a point either side of the peak. The amplitude deviation caused by the detuning would therefore be relatively small. If one were to operate away from the peak, one would be operating on the slope of the resonant response The steeper this slope, the more the amplitude changes as the resonant frequency shifts. For example, if vibration causes the resonant frequency to shift up the slope, the response would allow the vibration to amplitude modulate the RF. In one embodiment, the tank circuit can include extremely high Q air core transformers. The use of air core coils has been found to exhibit a free air Q that is typically greater than 300, and can be in the order of 400, 500, 600, or even as high as 700. This high Q resonant circuit rejects the harmonics emanating from the RF amplifier, which incorporates the harmonic inducing ferrite cores as well as nonlinear semiconductor power components.

A high Q tuned circuit exhibits low RF losses and a high voltage at resonance. A high Q reduces the amplitude of the harmonics, and their associated errors. In an aspect of the current invention, the tank circuit of the RF system has an advanced coil design with a high Q. This is due to a number of factors. The coil box is large with respect to the coil (at least x2) and it is constructed from extruded aluminum with no seams in the radial dimension. The coil aspect ratio of length to diameter is reasonably close to unity.

When current flows in a conductor, power is dissipated in the resistance of the conductor in the form of heat. The amount of power dissipated by the conductor is directly proportional to the resistance of the wire, and to the square of the current through it. The greater the value of resistance or current, the greater is the power dissipated. The systems described above use transformers that include windings. Conventionally, the primary and secondary windings of a transformer are usually made of low-resistance copper wire.

The resistance of a given winding is a function of the cross-sectional area of the wire and its length. Loss can be minimized by using the proper diameter wire. Large diameter wire is required for high-current windings, whereas small diameter wire can be used for low-current windings. However, when the current is an alternating current, magnetic forces push the flux of electrons within the wire towards the outside, and most of the current is conducted along the outer surface or skin of the wire. This skin effect is frequency dependant and reduces the effective wire cross section. This, in turn, reduces the wire's conductance and increases its resistance. Litz wire has been used to address this problem. Litz wire comprises a conductor consisting of a number of separately insulated strands that are bundled together. When the diameter of the individual strands is comparable to the skin depth of the RF current, the skin depth goes completely through the wire, the RF resistance is essentially the same as the DC resistance, and most of the areas of each wire is usable for conducting RF current. Since each strand tends to take all possible positions in the cross section of the entire conductor, this design equalizes the flux linkages (and reactance) of the individual strands causing the current to spread uniformly throughout the conductor. The use of Litz wire thus reduces the skin effect experienced with a solid conductor. As a result there is less heating and the coil itself runs at a lower temperature. By using bundles of fine insulated wire, the surface area of the wire is greatly increased in proportion to its volume. This produces lower overall resistance for a bundle of wire of a given diameter. For this reason, the secondary windings of RF transformers are often produced with Litz wire to reduce the resistance in the transformer and the associated power loss. This reduction in power loss increases the system's Q, and decreases transformer winding dimensional changes from heating.

Thus, in one embodiment, the secondary windings of the RF coil are constructed with 450-strands of number 46 AWG (American Wire Gauge) wire, each strand having a diameter of 1.57 mils. As explained above, with this type of wire, the skin depth is comparable to the diameter of the wire, so that the entire volume of the wire contributes to its RF conductivity, thereby making the RF resistance the same as the DC resistance. The RF current flowing in the wire is only about 1.5A at maximum mass. As a result there is little heating and the coil itself runs at very low temperature. This contributes to mass accuracy by enhancing system stability.

Utilizing Litz wire, intrinsic coil Q's of greater than 300 -- for example in the range of 500 to 700 -- can be attained. When such coils are incorporated into a mass spectrometer system, a Q in the order of greater than 300, e.g., in the region of 500 to 700, is achievable.

In order to generate the required high RF voltages, the tank circuit must resonate at the selected frequency or the frequency must be chosen to resonate with the tank circuit. In one embodiment, the frequency is fixed, and one or more elements of the tank circuit are adjustable to allow optimum resonance to be achieved. The introduction of a shorted loop within the transformer may be used to reduce the coil's inductance. This loop is typically of solid copper with a large cross section to reduce resistance. The transformer's inductance can be adjusted by varying the angle of the loop and therefore the cross section of the transformer's flux which is shorted.

Unfortunately, the current which flows within the shorted loop is substantial and the power losses reduce the Q of the tank circuit. In addition, heating of the shorted loop can detune the tank circuit, increasing losses further. This power must come from the RF power supply which in turn generates more heat within the instrument's enclosure.

These problems are mitigated by constructing the shorted loop from Litz wire. The parameters such as wire gauge and number of turns are selected such that the skin depth is larger than the radius of the wire, and the RF resistance is essentially the same as the DC resistance. In some embodiments, in excess of 4000 strands of wire can be used. For example, one embodiment employed a loop of 5000 strands of 1000 gauge Litz wire in a system operating at frequencies in excess of 1 MHz. While it might have been expected that this configuration would be ineffective because Litz wire loses its effectiveness (its ability to minimize loss due to skin effect) above 500 kHz, the system showed surprisingly good results. A classic tuning loop constructed from 1/8" copper rod became hot enough after operation at high power to be painful to the touch, but the Litz wire loop (5000 strands of 1000 gauge Litz wire) was comparatively cool. When the loop is solid copper, the heating causes dimensional changes which cause the tank circuit to drift out of tune. A tank circuit even marginally out of tune is less able to reject harmonics than one which is in tune. The power dependant de-tuning is therefore a source of drift which is intolerable in an accurate mass system.

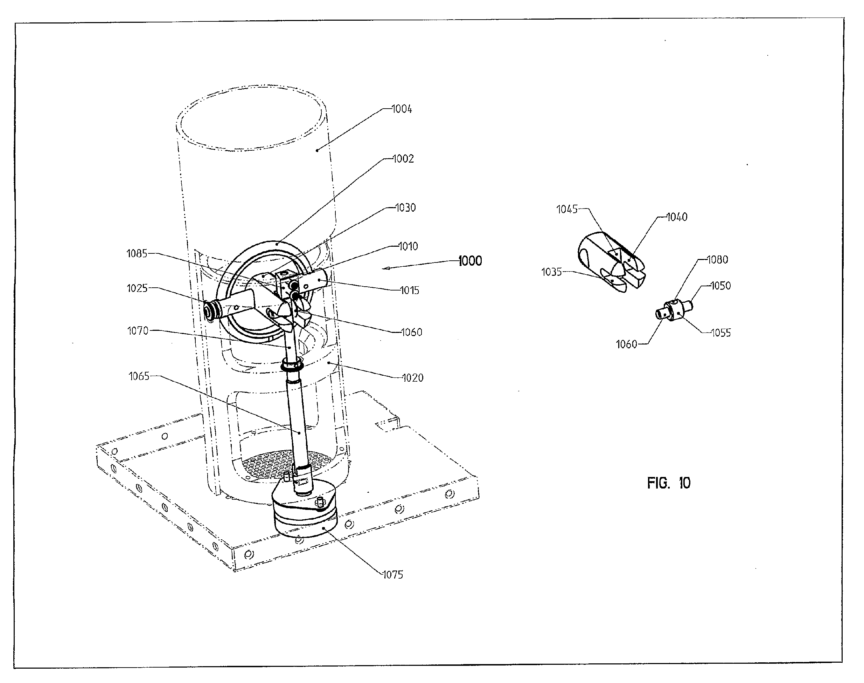

Fig. 10 illustrates a device 1000 that can be utilized to rotate or vary the angle of the plane of loop 1002 within the cross section of the transformer's 1004 flux. The loop 1002 is disposed within a slot 1010 of an elongated member 1015, the elongated member 1015 extending from one side of a housing 1020 to the other, and being rotatably retained in apertures 1025 herein. Rotation of the elongated member 1015 is facilitated via a movable element 1030 which is securely attached via a securing means (not shown) to the elongated member 1015, and ultimately to the loop 1002. The movable element 1030 comprises two slots 1035, 1040 orthogonal to and intersecting one another, and forming central void 1045. Located securely within the slots 1035, 1040 is an actuating nut 1050, which comprises a bush 1055 and a segmented rod 1060, the segmentation being formed by the bush 1055. As shown, the segmented rod 1060 is securely retained in at least a portion of the first slot 1035. The bush 1055 is disposed within at least a portion of the second slot 1040, and also passes through the void 1045. Rotation of the loop 1002 is facilitated by an actuation member 1065 comprising a first threaded portion 1070 at one end. The actuation member is connected to a stepper motor 1075 at the other end. The threaded portion 1070 is disposed within a second threaded portion 1080 of the bush 1055. Second threaded portion 1080 is oriented in a direction orthogonal to the axis of the bush 1055 itself. In operation, the stepper motor 1075 causes the actuation member 1065 to rotate; rotation of the threaded portion 1070 of the actuation member 1065 causes the actuating nut 1050 to move along the axis of the actuation member 1065. The segmented rod 1060 is securely retained within the slots 1035, 1040 of the movable element 1030, and consequently causes the movable element 1030 to move along the axis of the actuation member 1065, rotating on the axis of the elongated member 1015. Since the movable element 1030 is securely attached to the elongated member 1015, and the loop 1002 is securely retained within the elongated member 1015, the loop 1002 is therefore caused to rotate, or change its angle within the housing 1020 as shown. The actuating nut 1050 is prevented from leaving the first threaded portion 1070 of the actuation member 1065 when physical contact being made between the movable element 1030 and a "stop" 1085, which can be provided by a discrete element (as shown) or can be part of the actual housing 1020.

Utilizing the methods of calibration and optimizing the apparatus of a mass spectrometer according to the techniques described above provides for more accurate results in terms of mass determination. The techniques can be implemented in any mass spectrometer, including those listed above. When utilized in a "beam machine" such as a triple quadrupole mass spectrometer, the techniques make it possible to better isolate precursor ions or product ions, and provide a more accurate determination of results. This is because the mass filter must be set accurately, which is a distinct requirement from being able to determine the mass from an acquired spectrum. For example, a neutral loss scan requires both Q1 and Q3 to scan with a deterministic mass difference. When either one or both of the mass filters are set to high resolution, the precision needed to pass a particular parent to product transition is proportionately difficult. The method of calibrating the mass scan function rather than the acquired data is therefore a requirement for successful operation. The enhancements in the techniques described above are especially beneficial in this regard.

The accuracy of mass determination using the techniques described herein, generally speaking, is better than 50 ppm (parts per million) of the mass to be determined, for fairly noise-free spectra. With optimized conditions, mass accuracy better than 5 ppm, or 1 pmm can be achieved. In some cases, the mass of the monoisotopic peak can be reflected with substantially no error, which is down to the sub ppm level.

Figure 8 illustrates an exemplary mass spectrometer configured to implement the techniques described above. A quadrupole mass filter 800 includes two pairs of elongated conductive rods, 802, 804, and 806, 808, disposed in a configuration that provides a quadrupole field through which ions of the material under investigation travel. The rods are connected to radio frequency (RF) amplifier 810 via the transformer 812 and to DC amplifiers 814 and 816. The resonant circuit, including the rods, capacitors 818, stray capacitance and transformer windings, form a tank circuit having a Q value.

In operation, a mass control value is applied to an algorithm within a digital signal processor 820 which controls sweep generator 822. DC/RF ratio circuit 824 applies a swept voltage to the RF amplifier 810 which applies a sweep voltage to the transformer primary winding 826, to the DC amplifiers 814 and 816, which in turn apply DC voltages to the windings. The DC/RF ratio circuit assures that the amplitude ratio remains appropriate throughout the sweep. The RF control loop includes RF detection capacitor(s) 828 and RF detection circuit(s) 830 which sense the amount of generated RF. The RF/DC control circuit uses the RF detection system to regulate the applied RF voltage. The mass filtering action of the quadrupole mass filter is provided by scanning an analogue system, the RF sweep generator, which is digitally controlled by the digital signal processor 820.

Figure 9 shows a second exemplary mass spectrometer, a quadrupole ion trap 900 including a ring electrode 902 of hyperbolic configuration and two end caps 904 and 906 facing one another. RF voltage provided by RF generator 908 is applied between the end caps 904, 906 and the ring electrode 902 by a radio frequency (RF) amplifier 910 to generate the trapping fields. The digital signal processor or computer 912 drives a sweep generator 914 which forms a sweep control voltage for the RF generator 908, and ultimately the RF amplifier 910 which applies a swept RF voltage (via the tank circuit 940) between the end caps 904, 906 and the ring electrode 902 to thereby selectively eject ions.

One of the end caps 904 includes an electron beam aperture 916 through which an ionizing electron beam, for ionizing the sample molecules which are introduced into the ion storage region 918, projects. The opposite end cap 906 is perforated as illustrated to allow ions which are unstable in the fields of the ion trap to exit and be detected by an electron multiplier 920 which generates an ion signal on line 922. The signal on line 922 is converted from current to voltage by an electrometer 924. The results are summed and stored by the unit 926 and processed by unit 928. The digital signal processor 912 is connected to the RF generator 910 to allow the magnitude of the frequency of the RF voltage to be varied. This provides for mass selection.

The digital-to-analog converter (DAC) (not shown) is connected to the RF trapping field generator 908 and RF amplifier 910 for controlling the amplitude of the output voltage. In this schematic, the hyperbolic end caps 904, 906 are connected to secondary winding(s) 930 of a coupling transformer 932 having a center tap 934 connected to ground. The transformer 932 primary winding 936 is connected to a supplementary RF frequency generator 938.

The mass axis is calibrated for a fixed value of supplemental frequency. Ideally, mass (m) is linearly related to the voltage applied (V) and to the DAC control value. Using a calibration material suitable for use with the ionization method such as PFTBA for electron impact ionization or MRFA for electrospray ionization, for example, with masses at well known values distributed across the mass range of interest, a piecewise linear calibration curve is determined between the DAC value and the mass of the ion that is resonantly rejected for the fixed supplemental field. This curve establishes the DAC values to bring a given mass into resonance with the fixed supplemental field. With the mass axis calibration established for resonance ejection, to isolate any particular mass (m) within the calibrated range, the DAC value corresponding to the mass is taken from the calibration curve and set into the DAC as the maximum value of the RF voltage ramp. As the RF voltage ramps up, the ions are ejected from the trap up to the mass limit of the analyzer as determined by the design parameters such as r0, RF frequency, resonant ejection frequency and the maximum RF voltage.

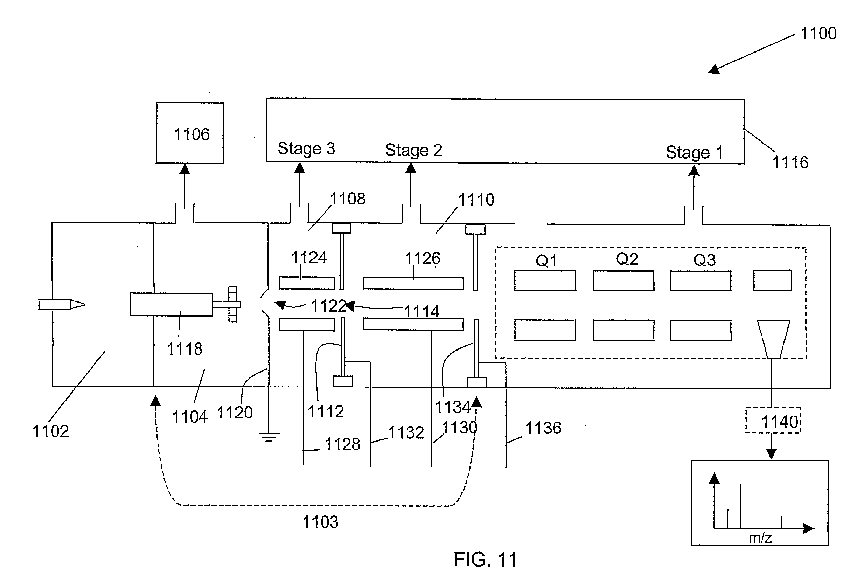

A triple quadrupole mass spectrometer 1100 that is configured for LC/MS applications is shown in Figure 11, and is described in more detail in U.S. Patent No. 4,234,791. An atmospheric pressure ion source in chamber 1102 is interfaced to a tandem or triple mass quadrupole mass analyzer 1103, in this example via three vacuum pumping stages 1104, 1108 and 1110. The first stage 1104, which has the highest pressure, is evacuated by an oil-filled rotary vane vacuum pump 1106. Other types of vacuum pumps may also be used for this stage, such as a diaphragm pump or scroll pump. The second and third stages 1108 and 1110 are separated by a lens 1112 with an orifice 1114, and are evacuated by separate vacuum pumping stages, preferably using a hybrid or compound turbomolecular pump 1116, although separate vacuum pumps may also be used for this purpose.

The ion source of the described triple quadrupole mass spectrometer is an atmospheric pressure ion source 1102 that may be an electrospray ion source, atmospheric pressure chemical ionization source, photo ionization source or other suitable technology. With these ion sources, sample is introduced into the chamber 1102, which is at atmospheric pressure, and ionized. The ions are drawn through a capillary 1118, which may be heated, into chamber 1104. The end of the capillary 1118 is opposite a conical skimmer 1120 which includes a central orifice or aperture 1122. The skimmer 1120 separates the low pressure stage 1104 from the lower pressure stage 1108. A portion of the ion and gas flow is skimmed from the free jet expansion leaving the capillary 1118 and enters the second lower pressure stage 1108. The ions which travel through the skimmer 1120 are guided into the mass analyzer 1103 by first and second multipole ion guides 1124 and 1126. The ions guides 1124, 1126 are mounted coaxially using insulating holders (not shown). The quadrupole ions guides 1124, 1126 are operated by applying RF voltages 1128 and 1130 to the rods which guide ions as is well known. Ions which enter the second 1108 and third 1110 stages drift under the influence of DC voltage 1132 applied between the skimmer lens 1120 and lens 1112, by DC voltage 1136 applied between the lens 1112 and the lens 1134, and by DC offset voltages (not shown) applied to ion guides 1124 and 1126. The quadrupoles Q1 and Q3 are quadrupole filters or mass spectrometers each driven by a circuit such as that shown in Figure 1.

MS/MS experiments are often carried out in triple quadrupole mass spectrometers, such as the one illustrated in FIG. 11. These experiments generally involve selecting specific precursor ions with Q1, fragmenting the precursor ions in Q2 via collisions to produce fragment or product ions, and mass resolving the product ions with Q3. It is well known that several scanning mode techniques can aid in determining the constituents of an unknown substance or identifying compounds in complex mixtures, when utilizing these types of experiments:
(1) Setting Q1 at a particular precursor ion (m/z value) to isolate and transmit a small range of mass resolved ions into the collision cell Q2, and then scanning via Q3 to provide the mass spectrum of the product ions.
(2) Setting Q3 at a particular product ion (m/z value) and then scanning Q1 to provide a precursor ion spectrum.
(3) Scanning both Q1 and Q3 simultaneously with a fixed m/z difference between them, to provide a neutral loss spectrum.

Figure 12 schematically shows an arrangement for a conventional magnetic field type mass spectrometer 1200. The mass spectrometer 1200 comprises an ion source 1202, an electrode 1204 for ion acceleration, a power supply for ion acceleration 1206, a magnetic field entrance slit 1208, a magnetic field exit slit 1210, a magnet for analysis 1212, a grounding electrode 1214, an electrode for current detection 1216, and an electrometer 1218.

Ions which are generated from the ion source 1202 are accelerated to a constant energy level by the ion accelerating electrode 1204 and are introduced into the magnetic field formed in the analyzing part of the magnet 1212 for analysis. In the magnetic field, ions travel a circular motion along a trajectory having a radius determined by momentum of the ions and the magnetic field strength. The magnetic field exit slit 1210, which is provided at the exit of the magnetic field, is arranged to allow passage of only ions moving along a trajectory with a predetermined radius determined by the acceleration energy, the mass-to-charge ratio and the velocity of the ions.

In the examples of Figures 8, 9 and 11, the mass of the ion which is either transmitted by a quadrupole filter or mass analyzer or which is ejected by the ion trap is determined by the amplitude of the applied RF sweep voltage, the analog system. The calibration curve for the particular filter, mass analyzer or ion trap creates a precise empirical relationship between the setting of the digital to analog converters (providing digital control) for the RF trapping voltage and the mass of the ion which is resonantly ejected and detected at the selected fixed supplemental field for the particular values of DAC setting, i.e. RF trapping field. The calibration curve is generally established using a calibration reference sample such as PFTBA or Poly Tyrosine or Poly Ethylene Glycol (PEG) that has masses at well known values distributed across the mass regions of interest. From the calibration chart prepared, one can select the value of the DAC which will cause ejection or selection of any m/z value.

In the example of Figure 12, the mass of the ions that are transmitted by the magnetic field analyzer is determined by the amplitudes of the applied magnetic, electric and acceleration fields (the analog systems). As above, once a calibration chart is prepared, one can select a combination of DAC values (providing digital control), which will cause selection of a specific m/z value.

The methods of the invention can be implemented in digital electronic circuitry, or in computer hardware, firmware, software, or in combinations of them. The methods of the invention can be implemented as a computer program product, i.e., a computer program tangibly embodied in an information carrier, e.g., in a machine-readable storage device or in a propagated signal, for execution by, or to control the operation of, data processing apparatus, e.g., a programmable processor, a computer, or multiple computers. A computer program can be written in any form of programming language, including compiled or interpreted languages, and it can be deployed in any form, including as a stand-alone program or as a module, component, subroutine, or other unit suitable for use in a computing environment. A computer program can be deployed to be executed on one computer or on multiple computers at one site or distributed across multiple sites and interconnected by a communication network.

Method steps of the invention can be performed by one or more programmable processors executing a computer program to perform functions of the invention by operating on input data and generating output. Method steps can also be performed by, and apparatus of the invention can be implemented as, special purpose logic circuitry, e.g., an FPGA (field programmable gate array) or an ASIC (application-specific integrated circuit).

Processors suitable for the execution of a computer program include, by way of example, both general and special purpose microprocessors, and any one or more processors of any kind of digital computer. Generally, a processor will receive instructions and data from a read-only memory or a random access memory or both. The essential elements of a computer are a processor for executing instructions and one or more memory devices for storing instructions and data. Generally, a computer will also include, or be operatively coupled to receive data from or transfer data to, or both, one or more mass storage devices for storing data, e.g., magnetic, magneto-optical disks, or optical disks. Information carriers suitable for embodying computer program instructions and data include all forms of non-volatile memory, including by way of example semiconductor memory devices, e.g., EPROM, EEPROM, and flash memory devices; magnetic disks, e.g., internal hard disks or removable disks; magneto-optical disks; and CD-ROM and DVD-ROM disks. The processor and the memory can be supplemented by, or incorporated in special purpose logic circuitry.

To provide for interaction with a user, the invention can be implemented on a computer having a display device, e.g., a CRT (cathode ray tube) or LCD (liquid crystal display) monitor, for displaying information to the user and a keyboard and a pointing device, e.g., a mouse or a trackball, by which the user can provide input to the computer. Other kinds of devices can be used to provide for interaction with a user as well; for example, feedback provided to the user can be any form of sensory feedback, e.g., visual feedback, auditory feedback, or tactile feedback; and input from the user can be received in any form, including acoustic, speech, or tactile input.

The invention has been described in terms of particular embodiments. Other embodiments are within the scope of the following claims. For example, the steps of the invention can be performed in a different order, and/or combined, and still achieve desirable results. While to the techniques of the invention have been described in the context of applications related to quadrupole field devices, they are more broadly applicable and could be used with any device in which the mass analysis characteristic of the device is scanned to selectively facilitate the passage of ions.

## Claims

1. A mass spectrometer, comprising:
a mass selection means for determining a mass of a selected ion, the mass selection means comprising a control means capable of providing an analog control voltage, the control means being capable of providing mass selection that varies linearly, the control means comprising one or more elements disposed in a thermally controlled environment.

2. A mass spectrometer according to claim 1, wherein:
the mass selection is calibrated to an accuracy of 1 mmu across the range of 1500 AMU.

3. A mass spectrometer according to claim 1, wherein:
the mass selection is calibrated to a linearity of at least two parts in 1,500,000.

4. A mass spectrometer according to claim 1, wherein:
the thermally controlled environment comprises one or more resistive heating elements integrated or embedded into a printed circuit board.

5. A mass spectrometer according to claim 4, wherein:
the printed circuit board comprises a boundary defining a thermally controlled region by one or more gaps, slots, or perforations.

6. A mass spectrometer according to claim 4, wherein: the heating elements are configured to regulate a temperature of the thermally controlled environment within a range of +/-0.5ºC.

7. A mass spectrometer according to claim 4, wherein:
the heating elements are configured to regulate a temperature of the thermally controlled environment within a range of +/-0.05ºC.

8. A mass spectrometer according to claim 4, wherein:
the thermally controlled environment comprises an insulation member substantially covering a surface of a temperature controlled region.

9. A mass spectrometer according to claim 1, further comprising:
a mass analyzer into which ions are introduced for mass analysis, the mass analyzer comprising at least 2 pairs of hyperbolic rods; and
wherein the rods are fabricated to an accuracy of better than 2 parts in 6000.

10. A mass spectrometer according to claim 10, wherein:
the rods are fabricated to an accuracy of better than 1 part in 6000.

11. A mass spectrometer according to claim 9, wherein:
the rods are fabricated to an accuracy of better than 2 parts in 8000.

12. A mass spectrometer according to claim 1, further comprising:
a mass analyzer comprising a resonant tank circuit, the resonant tank circuit comprising at least two pairs of conductive rods, a RF amplifier, a transformer, a DC amplifier and at a capacitor.

13. A mass spectrometer according to claim 11, wherein:
the tank circuit has a Q of greater than 300.

14. A mass spectrometer according to claim 11, wherein:
the tank circuit has a Q of greater than 700.

15. A mass spectrometer according to claim 11, wherein:
at least one winding of the transformer comprises multi-stranded litz wi re.

16. A mass spectrometer according to claim 11, wherein:
a tuning ring of the transformer comprises litz wire.

17. A mass spectrometer according to claim 16, wherein:
the tuning ring comprises litz wire having a gauge and number of turns such that an RF resistance of the tuning ring is substantially zero.
